# FASCICULE DE BREVET EUROPEEN

(11) **EP 2 769 473 B1**
(45) Date de publication et mention de la délivrance du brevet: **29.07.2015**
(21) Numéro de dépôt: 12769106.1
(22) Date de dépôt: 08.10.2012
(51) Int. Cl.: H03M 1/08, H03M 1/74

(54) **CONVERTISSEUR NUMERIQUE-ANALOGIQUE**
DIGITAL-ANALOG-UMSETZER
DIGITAL-TO-ANALOGUE CONVERTER

(30) Priorité: 21.10.2011 FR 1159577
(43) Date de publication de la demande: 27.08.2014
(73) Titulaire: E2V Semiconductors, 38120 Saint Egrève (FR)
(72) Inventeur: BORE, François, F-38420 Revel (FR); WINGENDER, Marc, F-38120 Saint Egreve (FR); DUMAINE, Emmanuel, F-38360 Sassenage (FR)
(74) Mandataire: Guérin, Michel
(86) Numéro de dépôt international: PCT/EP2012/069828
(87) Numéro de publication internationale: WO 2013/056997

(56) Documents cités:
- JP-A- 3 044 216
- US-A1- 2006 022 856
- MYUNG-JUN CHOE ET AL: "A 1.6GS/s 12b return-to-zero GaAs RF DAC for multiple Nyquist operation", SOLID-STATE CIRCUITS CONFERENCE, 2005. DIGEST OF TECHNICAL PAPERS. ISS CC. 2005 IEEE INTERNATIONAL SAN FRANCISCO, CA, USA FEB. 6-10, 2005, IEEE, PISCATAWAY, NJ, USA, 1 janvier 2005 (2005-01-01), pages 112-587VOL.1, XP031173671, DOI: 10.1109/ISSCC.2005.1493894 ISBN: 978-0-7803-8904-5

## Description

L'invention concerne les convertisseurs numériques analogiques à conversion en courant. Les convertisseurs en courant comprennent plusieurs sources de courant de valeurs identiques ou pondérées, de préférence pondérées pour réduire la taille du circuit ; le signal numérique à convertir est un mot binaire dont les bits servent à commander individuellement les différentes sources pour autoriser ou interdire le passage de courant de chaque source vers une charge commune ; la charge exerce une fonction d'additionneur analogique car la tension qui se développe aux bornes de la charge dépend de la somme des courants injectés et représente une valeur analogique du mot binaire d'entrée.

En pratique, chaque source de courant alimente une paire de branches différentielles, à savoir une branche impaire et une branche paire ; chaque branche comprend un transistor respectif, le courant de collecteur représentant le courant de la branche ; les deux transistors sont commandés respectivement par un bit d'entrée et son complément. L'un des transistors est donc conducteur pendant que l'autre est bloqué et réciproquement, selon la valeur du bit d'entrée. La charge de la branche impaire est commune à toutes les branches impaires, et la charge de la branche paire est commune à toutes les branches paires.

Parmi les problèmes qui se posent dans ce type de convertisseur, on a constaté que les commutations des transistors au moment d'un changement de mot binaire introduisaient un bruit de commutation important. La commutation est simultanée (sous la commande d'une horloge) pour tous les transistors. Mais les temps de réponse des différents transistors sont très dispersés. Et le temps de réponse global dépend de façon significative de la différence entre deux mots binaires consécutifs à convertir. Plus la fréquence F de l'horloge de cadencement des données numériques augmente plus la linéarité du convertisseur et la pureté spectrale du signal de sortie se dégradent.

De plus, le spectre de puissance du signal de sortie est limité par la fréquence d'horloge utilisée dans cette commutation. Ce spectre (puissance du signal de sortie en fonction de la fréquence) est en théorie une courbe à lobes multiples en forme de sinus(x)/x présentant une atténuation très forte autour de la fréquence d'horloge, et un pic à une fréquence égale à une fois et demi la fréquence d'horloge. Il est donc difficile d'obtenir un signal de sortie de niveau suffisant pour certaines plages de fréquences, notamment autour de la fréquence d'horloge, et difficile d'obtenir un signal de sortie de niveau indépendant de la fréquence dans la gamme de fréquences désirée.

On a déjà proposé, par exemple dans la publication US2006/0022856, une amélioration consistant à utiliser une demi-période d'horloge pour interdire le passage du courant vers la charge pendant le moment où on commute le mot binaire à l'entrée. On autorise à nouveau le passage du courant vers la charge pendant la demi-période suivante lorsque le nouveau mot binaire est bien établi à l'entrée du convertisseur.

Par exemple, en supposant que le mot d'entrée est introduit dans un registre tampon (ou "latch") actionné par une horloge régulière CLK, CLKb où CLK représente un niveau actif de l'horloge pendant une demi-période et CLKb représente un niveau complémentaire inactif pendant la demi-période suivante, on prévoit que le registre tampon est chargé par un nouveau mot binaire sur le front descendant de CLK, que le passage du courant est alors interdit pendant la demi-période CLKb=1 qui suit ce front descendant, et que le passage de courant est à nouveau autorisé pendant la demi-période CLK=1 qui va suivre, le nouveau mot binaire étant alors bien stabilisé. Plus précisément, l'interdiction du passage du courant consiste à dériver le courant en dehors des charges résistives sans interruption de ce courant dans les transistors des branches paire et impaire.

De tels convertisseurs sont dits convertisseurs RTZ, c'est-à-dire convertisseurs avec retour à zéro en raison de ce que le signal de sortie analogique va passer périodiquement à zéro pendant les demi-périodes CLKb où CLK=0.

D'une part on améliore la pureté spectrale du signal de sortie en raison de la suppression des dispersions de commutation des sources de courant, et d'autre part le spectre du signal de sortie est alors mieux distribué et ne comporte pas de creux au voisinage de la fréquence d'horloge. Cependant, la puissance du signal de sortie est plus faible.

On a proposé par ailleurs des convertisseurs qui travaillent de manière complémentaire pendant les deux demi-périodes de la fréquence d'horloge. Pendant la première demi-période les courants de transistors des branches différentielles impaires sont envoyés à une charge impaire et les courants des branches différentielles paires sont envoyés à la charge paire. Pendant la demi-période d'horloge qui suit on croise les liaisons entre les transistors et les charges, envoyant les courants des branches impaires vers la charge paire et réciproquement ; ainsi, le signal de sortie du convertisseur transmet deux valeurs analogiques successives complémentaires (celle qui représente le mot binaire et celle qui représente le mot complémentaire) pendant deux demi-périodes successives du signal d'horloge. Il s'agit en quelque sorte d'une modulation supplémentaire du signal analogique de sortie, qui est décodée à l'utilisation. On double en quelque sorte la puissance du signal de sortie, et de plus on change le spectre de sortie en renforçant tout particulièrement la puissance pour des fréquences situées entre la moitié de la fréquence d'horloge et la fréquence d'horloge, et même au-delà.

Bien entendu, ce mode de commutation qui exige d'envoyer le courant des sources vers la charge pendant chacune des demi-périodes de l'horloge est incompatible avec le mode RTZ qui exige de dériver le courant hors de la charge (vers l'alimentation) pendant cette demi-période.

Un but de l'invention est d'obtenir à la fois une bonne pureté spectrale du signal de sortie et une puissance de sortie plus élevée que ce que permet l'art antérieur dans une large gamme de fréquences allant au-delà de deux fois la fréquence de l'horloge qui définit la cadence de renouvellement du signal numérique d'entrée.

Pour cela, l'invention propose d'utiliser un mode de retour à zéro pendant une fraction de temps inférieure à la demi-période d'horloge, et de diviser le reste de la période d'horloge en deux demi-temps pendant lesquels les liaisons entre sources de courant et charges sont alternativement directes et croisées.

Par conséquent, on propose selon l'invention un convertisseur numérique-analogique comportant au moins un ensemble de sources de courant, une paire respective de branches différentielles à deux transistors, reliée à chaque source de courant, un registre actionné à une fréquence d'horloge F et recevant une donnée numérique à convertir, le registre commandant les transistors des branches pour aiguiller individuellement les courants des sources de courant dans l'une ou l'autre des branches différentielles de chaque paire en fonction de la valeur de la donnée numérique à convertir, et une paire de charges résistives recevant les courants des branches différentielles pour produire un signal électrique de sortie différentiel dont la valeur analogique représente la donnée numérique à convertir, le convertisseur comportant encore un circuit d'aiguillage interposé entre les branches différentielles et les charges pour soit autoriser la transmission vers les charges des courants des branches différentielles soit dériver ces courants hors des charges, caractérisé en ce que :
- le circuit d'aiguillage comprend des moyens pour établir périodiquement à la fréquence d'horloge une dérivation suivie d'une autorisation, le rapport cyclique entre la durée d'autorisation et la période d'horloge étant compris entre 0,7 et 0,95,
- le circuit d'aiguillage comprend un étage d'aiguillage permettant soit une liaison directe soit une liaison croisée entre les branches différentielles et les charges, et des moyens pour commander l'étage d'aiguillage pour relier les branches différentielles aux entrées des charges directement pendant une première moitié de la durée d'autorisation et de manière croisée pendant la deuxième moitié de la durée d'autorisation, de manière à inverser le signe du signal électrique de sortie entre les deux moitiés de cette durée.

Le circuit d'aiguillage assure donc deux fonctions différentes, ces deux fonctions étant de préférence assurées par deux étages superposés entre les branches différentielles et le moyen d'addition. La première fonction (autorisation de transmission ou dérivation) est assurée par un premier étage d'aiguillage et la deuxième fonction (liaison directe ou croisée) est assurée par un deuxième étage d'aiguillage. Les étages peuvent se succéder dans un ordre ou dans l'ordre inverse depuis les branches différentielles vers le moyen d'addition, le premier étage étant de préférence interposé entre les branches différentielles et le deuxième étage.

Un circuit d'aiguillage à deux étages est de préférence commun à plusieurs paires de branches différentielles (mais de préférence pas toutes, c'est-à-dire que le convertisseur comportera plusieurs circuits d'aiguillage associés chacun à un groupe de paires de branches différentielles), les branches différentielles communes à un groupe étant alors réunies à l'entrée du circuit d'aiguillage associé à ce groupe.

Les circuits d'aiguillage comportent des paires de transistors associées à chaque branche différentielle pour effectuer un aiguillage symétrique pour les courants des deux branches différentielles. Des sources de courant auxiliaires identiques sont de préférence reliées entre le circuit d'aiguillage et une borne d'alimentation, pour faire circuler un courant non nul même dans celles des paires de transistors du circuit d'aiguillage qui sont connectées à une branche différentielle non parcourue par un courant.

Le calage temporel entre les fronts de transition des signaux qui commandent la dérivation et les signaux d'horloge est de préférence réglable, de même que le calage temporel entre les fronts de transition des signaux qui commandent le croisement entre les branches différentielles et les charges.

L'invention est particulièrement intéressante lorsque l'ensemble de sources de courant comprend des sources de courant ayant des valeurs pondérées selon une pondération binaire : la pondération entraîne une forte dispersion des temps de réponse des transistors des différentes branches différentielles, mais l'invention permet de compenser les inconvénients de cette dispersion.

D'autres caractéristiques et avantages de l'invention apparaîtront à la lecture de la description détaillée qui suit et qui est faite en référence aux dessins annexés dans lesquels :
- la figure 1 représente une partie d'un convertisseur numérique analogique de l'art antérieur ;
- la figure 2 représente la constitution d'un convertisseur selon l'invention ;
- la figure 3 représente un chronogramme de fonctionnement du convertisseur ;
- la figure 4 représente la constitution d'un convertisseur selon un autre mode de réalisation.

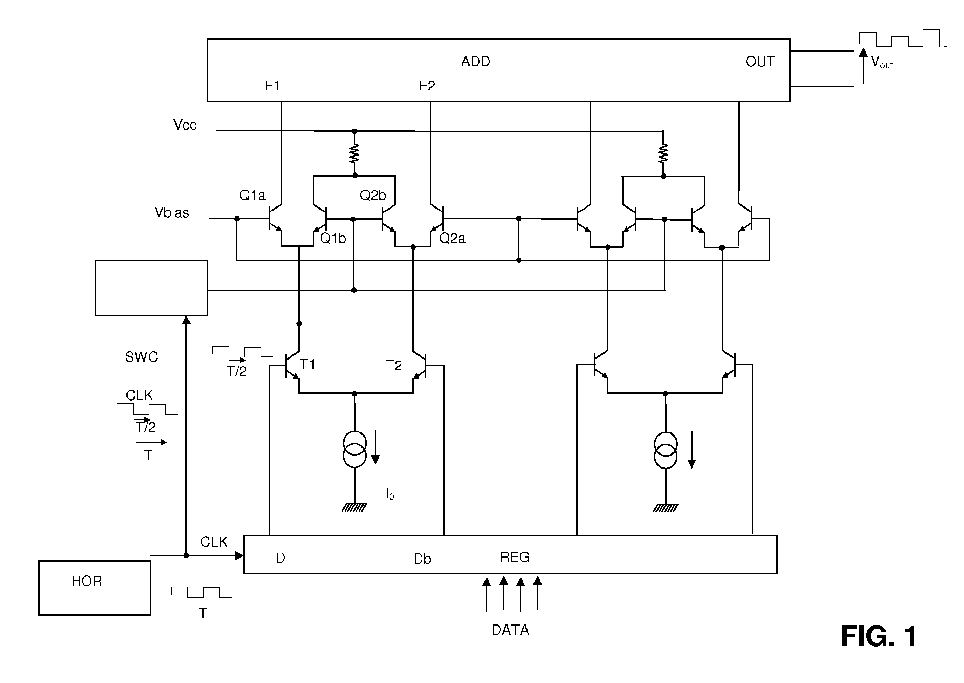

La figure 1 représente sous forme simplifiée le principe d'un convertisseur avec retour à zéro de l'art antérieur.

Un registre numérique REG reçoit une donnée numérique à convertir, sous forme d'un mot binaire. Le registre comporte pour chaque bit deux sorties, respectivement une sortie impaire fournissant le bit et une sortie paire fournissant son complément. Le convertisseur comporte autant de sections en parallèle qu'il y a de bits dans le mot à convertir. Seules deux sections du convertisseur sont représentées, correspondant à deux bits du registre. Une seule section, correspondant à un bit de sortie D et son complément Db sera décrite en détail. Les sorties des différentes sections sont des sorties en courant ; il y a pour chaque section une sortie impaire E1 et une sortie paire E2 ; elles sont complémentaires ; la sortie impaire fournit un courant (ici un courant entrant vers les branches différentielles) si le bit de registre correspondant est à 1 et ne fournit pas de courant si le bit de registre est à zéro ; la sortie paire fait l'inverse.

Les courants de sortie des différentes sections sont pondérés en fonction du poids qu'on affecte à chaque bit du mot à convertir. Les sources de courant internes à chaque section ont donc des valeurs pondérées en conséquence.

Les courants des sorties impaires sont additionnés dans un circuit d'addition ADD ; les courants des sorties paires sont également additionnées séparément dans ce circuit. L'addition peut se faire tout simplement grâce à une résistance de charge qui reçoit tous les courants des sorties impaires et une autre résistance de charge qui reçoit tous les courants des sorties paires. La différence Vₒᵤₜ entre les tensions aux bornes de ces résistances est une tension analogique différentielle qui représente la valeur numérique du mot binaire à convertir. Cette différence est fournie sur une sortie OUT du circuit d'addition ADD.

La section correspondant à un bit du mot à convertir comprend une paire classique de branches différentielles alimentées par un courant commun issu d'une source de courant I₀. La branche impaire comporte un transistor T1 rendu conducteur par un bit 1 dans le registre (c'est-à-dire un bit 1 sur la sortie impaire du registre) et bloqué par un bit 0 dans le registre. La branche paire comporte un transistor T2 rendu conducteur par un bit 0 dans le registre (donc un bit 1 sur la sortie paire du registre) et bloqué par un bit 1 dans le registre.

Les courants des collecteurs de ces transistors seraient appliqués directement au circuit d'addition dans le cas d'un convertisseur sans retour à zéro.

Ici, le convertisseur de la figure 1 est un convertisseur avec retour à zéro. Il comporte un circuit d'aiguillage permettant de laisser passer les courants vers le circuit d'addition ou au contraire de les dériver vers une borne d'alimentation. La branche différentielle impaire laisse passer son courant (s'il existe, c'est-à-dire si le registre contient un bit 1) vers un premier aiguillage à deux transistors Q1a et Q1b ; la branche paire laisse passer son courant éventuel vers un deuxième aiguillage à deux transistors Q2a, Q2b commandé en même temps que le premier aiguillage.

La commande des aiguillages, commune à tout le convertisseur est un circuit SWC qui reçoit un signal d'horloge périodique symétrique CLK à une fréquence F délivrée par un circuit d'horloge HOR. Les aiguillages sont dans un premier état pendant la demi-période où CLK =1 et dans un deuxième état pendant la demi-période où CLK=0. On notera CLKb le complément du signal CLK.

Les deux états des circuits d'aiguillage sont commandés par le circuit SWC en synchronisme avec les demi-périodes CLK et CLKb ; le registre est par ailleurs chargé avec une nouvelle donnée numérique à chaque période d'horloge sous la commande du signal CLK ; par exemple, le front descendant du signal CLK déclenche le report d'un nouveau mot binaire (présent à l'entrée du registre) sur les sorties du registre, en remplacement du mot binaire précédent.

La stabilisation de ce report et la stabilisation des courants sortant des branches différentielles prend un certain temps, ce temps n'étant pas nécessairement le même pour toutes les sections du convertisseur en raison des valeurs de courant différentes selon les sections : si les sections ont toutes le même poids en courant, il y a une certaine dispersion des valeurs de courant, mais surtout, si les sections sont pondérées de manière binaire, les valeurs de courant sont différentes par principe.

A cause de cela, on met pendant toute la demi-période où CLK=0 les aiguillages dans un premier état où les transistors Q1b et Q2b sont conducteurs et dérivent le courant des branches différentielles vers l'alimentation Vcc du circuit. La sortie du circuit SWC commande en conséquence les transistors Q1 b et Q2b.

Inversement, pendant toute la demi-période où CLK=1, les aiguillages sont mis dans un deuxième état par le blocage des transistors Q1b et Q2b, empêchant toute dérivation du courant ; les transistors Q1a et Q2a sont normalement conducteurs ; ils pourraient être commandés par une sortie complémentaire du circuit SWC mais dans l'exemple donné leur base est portée à un potentiel fixe Vbias qui les rend conducteurs. Le courant passe alors à travers le transistor Q1a ou le transistor Q2a selon le bit présent dans le registre REG. Ce courant est utilisé en conséquence par l'additionneur ADD.

La tension différentielle de sortie Vₒᵤₜ est une tension dont la valeur représente le mot binaire d'entrée, pendant la demi-période CLK=1 et qui revient à zéro pendant l'autre demi-période d'horloge.

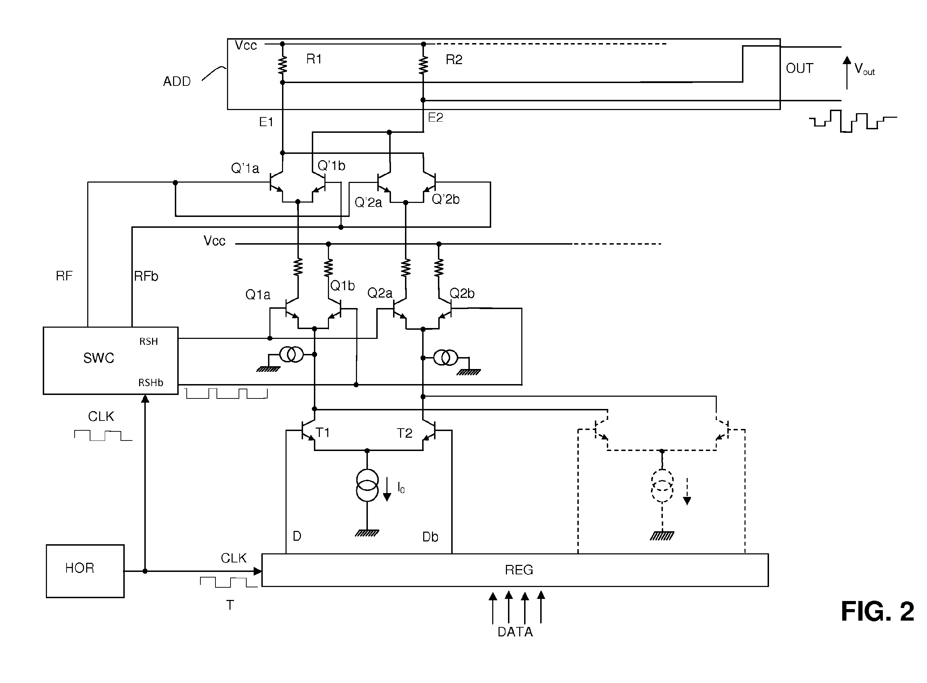

La figure 2 représente la modification selon l'invention. La structure générale du convertisseur avec une section pour chaque bit du registre est conservée ; les courants des différentes sections sont de préférence pondérés de manière binaire. Mais au lieu de comporter un seul étage d'aiguillage (à deux aiguillages) comme à la figure 1, la section comprend deux étages d'aiguillages superposés (c'est-à-dire en série) entre les branches différentielles (représentées par les collecteurs des transistors T1 et T2) et le circuit d'addition ADD.

Les éléments communs avec la figure 1 portent les mêmes références numériques et assurent les mêmes fonctions ; ils ne seront pas décrits à nouveau.

Le premier étage d'aiguillage comporte les transistors Q1a et Q1b pour la branche différentielle impaire et les transistors Q2a et Q2b pour la branche paire. Il assure la même fonction qu'à la figure 1 : autoriser le passage du courant des branches différentielles vers le circuit d'addition ou au contraire dériver ce courant vers l'alimentation Vcc.

Le circuit d'addition ADD peut être constitué simplement par deux résistances de charge identiques R1 et R2 alimentées par la tension d'alimentation Vcc. Il comprend deux entrées E1 (qu'on appellera entrée impaire) et E2 (entrée paire). Les entrées reçoivent chacune un courant d'une branche différentielle de la paire de branches de la section représentée.

Un circuit d'aiguillage à deux étages est de préférence commun à plusieurs paires de branches différentielles (mais de préférence pas toutes, c'est-à-dire que le convertisseur comportera plusieurs circuits d'aiguillage associés chacun à un groupe de branches différentielles) ; les branches différentielles d'un groupe sont alors réunies à l'entrée du circuit d'aiguillage associé à ce groupe, ce qui signifie que tous les collecteurs des branches paires de ce groupe sont reliés ensemble et tous les collecteurs des branches impaires sont reliés ensemble.

C'est ce qui est représenté à la figure 2 : les branches différentielles d'autres sections du convertisseur sont reliées aux branches différentielles de la première section de sorte que les circuits d'aiguillage sont communs à toutes les sections (ou au moins communs à un groupe de plusieurs sections). La branche différentielle impaire est alors en réalité constituée par la réunion de toutes les branches différentielles impaires d'un groupe de plusieurs sections, et la branche paire est constituée par la réunion de toutes les branches paires de ce groupe. Le circuit d'addition ADD joue alors essentiellement un rôle de conversion de courant en tension pour produire une tension proportionnelle à la somme des courants des branches de même parité. C'est pourquoi de simples charges résistives R11 et R2 peuvent suffire pour réaliser l'additionneur. Les autres groupes de sections du convertisseur sont reliés à ces mêmes charges résistives par les mêmes entrées E1 et E2.

La sortie différentielle OUT fournit une tension Vₒᵤₜ qui est la différence des tensions aux bornes des deux charges.

L'autorisation et la dérivation du courant sont commandées par le circuit SWC qui fournit deux signaux complémentaires RSH et RSHb sur ses deux sorties. Le signal RSH commande les transistors Q1a et Q2a du premier étage d'aiguillage ; le signal RSHb commande les transistors Q1b et Q2b de ce premier étage. L'autorisation de passage du courant est fournie par RSH au niveau haut, rendant conducteur les transistors Q1a et Q2a, et simultanément RSHb au niveau bas, bloquant les transistors Q1b et Q2b. La dérivation est commandée par RSHb au niveau haut, bloquant les transistors Q1a et Q2a, et RSH au niveau bas, rendant conducteurs Q1b et Q2b. A la différence de la commande décrite en référence à la figure 1, les durées des niveaux hauts de RSH et RSHb sur les sorties du circuit SWC ne sont pas égales à une demi-période. Au contraire, le rapport cyclique entre la durée du signal d'autorisation de passage de courant (RSH=1) et la période de l'horloge CLK est compris entre 0,7 et 0,95.

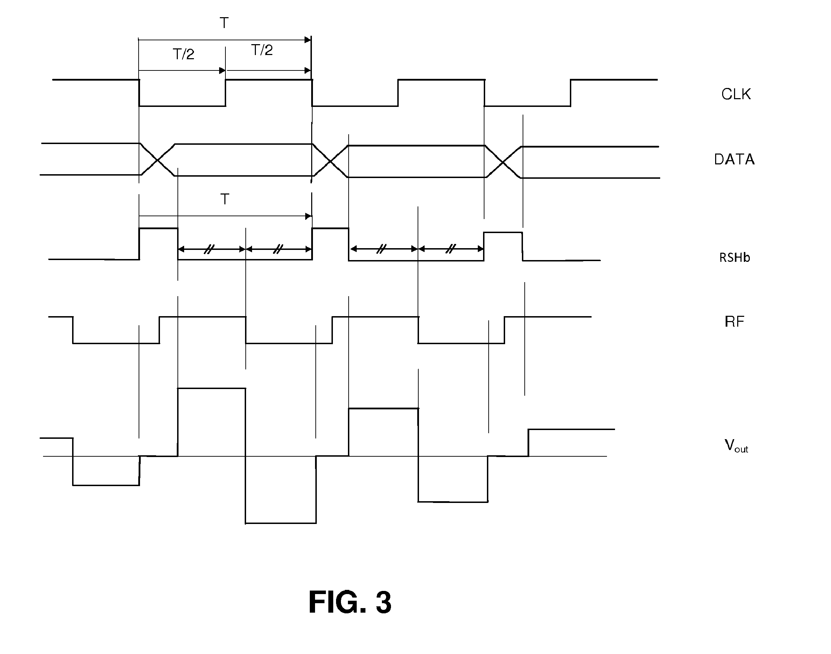

Le chronogramme de la figure 3 montre le signal dissymétrique RSH en relation avec l'horloge symétrique CLK de période T.

Les fronts de transition des signaux RSH et RSHb sont calés par rapport aux fronts du signal d'horloge de manière à n'autoriser la transmission de courant au circuit d'addition que lorsque les niveaux logiques en sortie du registre REG sont bien stabilisés. Le signal RSH passe au niveau haut de préférence au moment du front de descente de CLK. Mais il redescend au niveau 0 après une durée comprise entre 0,05 et 0,3 fois la période d'horloge.

Le circuit de la figure 2 comporte en outre un deuxième étage d'aiguillage comprenant deux transistors Q'1a et Q'1b pour la branche différentielle impaire et deux transistors Q'2a et Q'2b pour la branche différentielle paire. Lorsque les courants des branches différentielles ne sont pas dérivés vers l'alimentation par le premier étage, ils passent à travers ce deuxième étage.

Le deuxième étage d'aiguillage sert à aiguiller le courant de la branche différentielle impaire alternativement vers l'entrée impaire E1 (connexion qu'on appellera directe) puis vers l'entrée paire E2 (connexion qu'on appellera croisée) et à aiguiller réciproquement le courant de la branche différentielle paire alternativement vers l'entrée paire E2 (connexion directe) puis vers l'entrée impaire E1 (connexion croisée).

Pour cela, le transistor Q'1a est relié entre le transistor Q1a (sortie du premier aiguillage) et l'entrée E1, le transistor Q'1b est relié entre le transistor Q1a et l'entrée E2, le transistor Q'2a est relié entre le transistor Q2a et l'entrée E2, et enfin le transistor Q'2b est relié entre le transistor Q2a et l'entrée E1.

Les transistors Q'1a et Q'2a reçoivent un même signal de commande RF et les transistors Q'1 b et Q'2b reçoivent un signal complémentaire RFb. Les signaux RF et RFb sont périodiques à la période de la fréquence d'horloge Leur phase est calée par rapport au signal d'autorisation fourni par le circuit SWC de manière à présenter une transition de changement de niveau au milieu de la durée du signal d'autorisation comme cela est représenté sur le chronogramme de la figure 3. Dans l'exemple représenté, la durée du niveau haut de RF (et de même celui de RFb) est égale une demi-période d'horloge car c'est la manière la plus simple de réaliser les signaux RF et RFb, mais le point important est que la durée d'autorisation (RSH au niveau 1) soit divisée en deux parties égales avec respectivement RF=1 dans la première partie et RF=0 dans la deuxième.

Ainsi,
- en dehors du signal d'autorisation le courant des branches différentielles ne passe de toutes façons pas vers le circuit d'addition ADD ;
- pendant la première moitié du signal d'autorisation la connexion entre les branches différentielles et le circuit d'addition est directe ;
- pendant la deuxième moitié du signal d'autorisation, de même durée que la première moitié, la connexion est croisée.

La sortie OUT du convertisseur fournit un signal de tension modulée à la fréquence d'horloge et la modulation est symétrique puisque, en raison du croisement des liaisons, cette sortie fournit une tension analogique dont le niveau représente alternativement le mot binaire et son complément ; la durée pendant laquelle une tension représentant le mot binaire est fournie est de 0,35 fois T à 0,47 fois T, où T est la période d'horloge ; la durée pendant laquelle une tension représentant le complément du mot binaire est fournie a la même valeur.

Le chronogramme de la figure 3 représente le séquencement des signaux de commande ; les lignes du chronogramme sont les suivantes :
- horloge CLK symétrique de période T, le front descendant (dans cet exemple) définissant l'instruction de changement d'état des sorties du registre REG pour appliquer un nouveau mot binaire aux branches différentielles ;
- DATA : état des sorties du registre, avec un temps d'établissement des niveaux sur ces sorties après le front descendant d'horloge ;
- RSH, signal de commande du premier étage d'aiguillage ; sa période est T ; la durée des créneaux hauts de RSH est comprise entre 0,05 T et 0,3 T : la durée des créneaux bas est comprise entre 0,95T et 0,7xT ; le front montant de RSH coïncide de préférence avec le front descendant de l'horloge CLK et le créneau haut de RSH dure suffisamment longtemps pour que les sorties du registre soient stabilisées ;
- RF, signal de commande du deuxième étage d'aiguillage, avec la même période T que l'horloge ; la transition du niveau haut vers le niveau bas est située au milieu de l'intervalle pendant lequel RSH est au niveau bas.
- Vₒᵤₜ, tension analogique modulée en sortie du convertisseur.

Avec cette configuration de signaux de commande d'aiguillage on neutralise les risques de transitions indésirables en sortie du registre au moment d'un changement de mot binaire en entrée du convertisseur. Ceci donne une bonne pureté spectrale du signal de sortie. Et on conserve une puissance importante du signal analogique en sortie du convertisseur dans une bande spectrale autour de la fréquence d'horloge.

Si on subdivise le domaine spectral en quatre zones de Nyquist qui sont respectivement :
- fréquences 0 à F/2 où F est la fréquence d'horloge CLK ;
- fréquences F/2 à F ;
- fréquences F à 3F/2 ;
- fréquences 3F/2 à 2F
on a un très bon niveau de puissance dans les deuxième et troisième zones, qu'on n'aurait pas avec les solutions classiques. On peut même avoir une puissance acceptable dans une bonne partie de la quatrième zone de Nyquist.

Le choix de la durée de la dérivation du courant vers l'alimentation est lié aux performances de commutation du registre et des transistors T1 et T2 des branches différentielles. En effet, la dérivation doit être effective jusqu'à l'établissement ferme des nouveaux états de conduction des branches différentielles. On a constaté que la durée de dérivation pouvait rester comprise entre 5% et 30% de la période d'horloge T même si les sources de courant des branches différentielles sont à pondération binaire (cas défavorable en termes de dispersion de valeurs des courants des différentes sources).

Le calage des fronts de transition des signaux RSH et RF est de préférence réglable, et ceci individuellement pour chacun des groupes s'il y a plusieurs groupes. De même la durée de dérivation est de préférence réglable, individuellement pour chacun des groupes s'il y a plusieurs groupes.

Des sources de courant auxiliaires identiques sont de préférence reliées aux collecteurs des transistors T1 et T2 des branches différentielles, pour faire circuler un courant non nul même dans celles des paires de transistors du circuit d'aiguillage qui sont connectées à une branche différentielle non parcourue par un courant. Cela permet de limiter les variations de potentiel des collecteurs des transistors T1 et T2 (ces potentiels varient en fonction des valeurs de mots binaires). Ainsi, on peut éviter de trop forts déséquilibres de tensions base-émetteur des transistors des différentes paires de transistors des aiguillages. La valeur du courant de ces sources auxiliaires peut être d'environ 20% de la somme des courants des branches différentielles associées à un même circuit d'aiguillage.

Dans une variante de réalisation, le deuxième étage d'aiguillage, qui sert à croiser et décroiser les liaisons entre les branches différentielles et le circuit d'addition, n'est pas placé entre le premier étage et les charges résistives du circuit d'addition, mais il est placé entre les branches différentielles et le premier étage qui autorise ou dérive le courant.

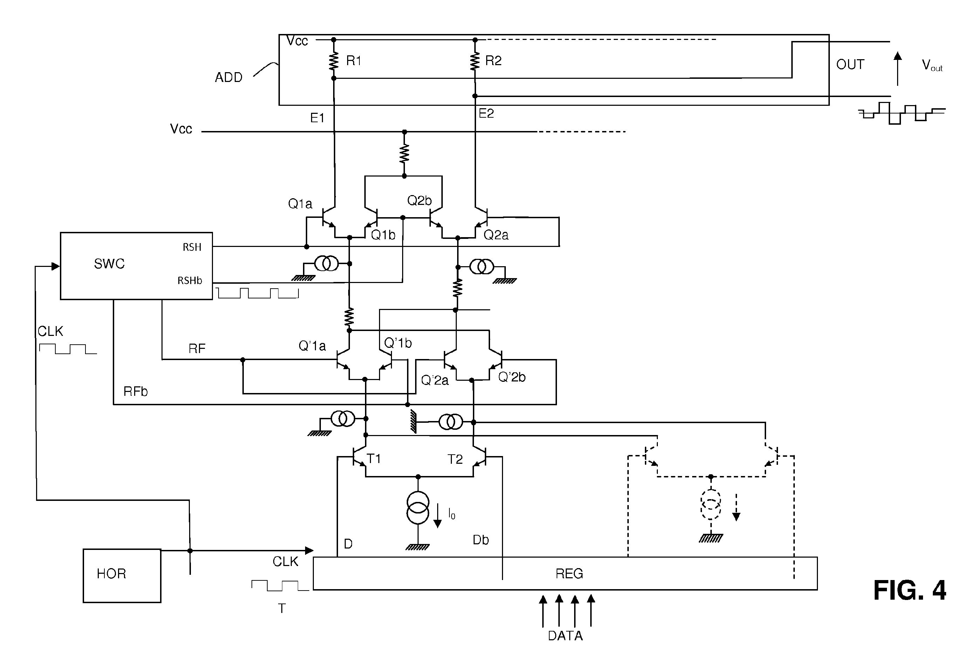

La figure 4 représente un exemple de réalisation de cette variante. La paire de transistors Q'1a, Q'1b du deuxième aiguillage est reliée directement au collecteur du transistor T1 ; la paire de transistors Q'2a, Q'2b est reliée au collecteur du transistor T2.

Les transistors Q'1 a et Q'2a sont rendus conducteurs par le signal RF au niveau haut et ils aiguillent alors le courant du transistor T1 vers la paire Q1 a, Q1 b du premier étage d'aiguillage, et de là vers l'entrée E1 en dehors des périodes de remise à zéro ; ils aiguillent en même temps le courant du transistor T2 vers la paire Q2a, Q2b udupremier étage d'aiguillage et de là vers l'entrée E2 en dehors des instants de remise à zéro.

Les transistors Q'1b et Q'2b sont rendus conducteurs par le signal RFb au niveau haut et ils croisent alors les liaisons : ils aiguillent le courant du transistor T1 vers l'entrée E2 à travers la paire de transistors Q2a, Q2b, et ils aiguillent le courant du transistor T2 vers l'entrée E1 à travers la paire Q1 a, Q1 b.

Dans le schéma de la figure 4 on prévoit de préférence comme à la figure 2 des sources de courant auxiliaires reliées aux collecteurs des transistors T1 et T2.

D'autres sources de courant auxiliaires peuvent en outre être prévues, aussi bien dans le schéma de la figure 2 que dans le schéma de la figure 4, aux points de jonction entre le premier et le deuxième aiguillages. Dans le schéma de la figure 2 elles seraient reliées aux émetteurs des paires de transistors Q1 a, Q1 B d'une part, Q2a, Q2b d'autre part. Dans le schéma de la figure 4, on les a représentées reliées aux émetteurs des paires Q'1a, Q'1b et Q'2a, Q'2b.

Le circuit selon l'invention est destiné à permettre une utilisation simultanée de l'étage d'autorisation et de l'étage de croisement des liaisons comme expliqué ci-dessus. Mais il permet aussi de fonctionner selon les modes de l'art antérieur si on supprime la commande de l'un ou l'autre des étages d'aiguillage. On choisira le mode de fonctionnement selon le spectre de signal désiré ; le mode selon l'invention, utilisant les deux étages d'aiguillage, est le plus intéressant pour un spectre de fréquences analogiques ayant des composantes dans les deuxième et troisième zones de Nyquist et même la quatrième.

Pour que le fonctionnement du convertisseur soit optimisé, il est préférable que l'horloge soit différentielle et distribuée dans toutes les sections du convertisseur à travers un arbre binaire différentiel équilibré en délai de transit d'information (et pas seulement en longueurs physiques des branches) et dont les noeuds présentent une résistance d'amortissement anti-rebond. La charge en courant des branches d'horloge ainsi distribuées peut être réduite en prévoyant de place en place des répéteurs (transistors additionnels) devant chaque groupe d'interrupteurs d'aiguillage.

## Revendications

1. Convertisseur numérique-analogique comportant au moins un ensemble de sources de courant, une paire respective de branches différentielles à deux transistors (T1, T2) reliée à chaque source de courant, un registre (REG) actionné à une fréquence d'horloge F et recevant une donnée numérique à convertir, le registre commandant les transistors des paires de branches pour aiguiller individuellement les courants des sources de courant dans l'une ou l'autre des branches différentielles de chaque paire en fonction de la valeur de la donnée numérique à convertir, et deux charges résistives (R1, R2) recevant les courants des branches différentielles pour produire un signal électrique de sortie différentiel dont la valeur analogique représente la donnée numérique à convertir, le convertisseur comportant encore un circuit d'aiguillage interposé entre les branches différentielles et les charges résistives, le circuit d'aiguillage comprenant un premier étage d'aiguillage (Q1a, Q1b, Q2a, Q2b) adapté pour soit autoriser la transmission vers les charges résistives des courants des branches différentielles soit dériver ces courants hors des charges résistives **caractérisé en ce que** :
- le premier étage d'aiguillage est adapté pour établir périodiquement à la fréquence d'horloge une dérivation suivie d'une autorisation, le rapport cyclique entre la durée d'autorisation et la période d'horloge étant compris entre 0,7 et 0,95,
- le circuit d'aiguillage comprend en outre:
un deuxième étage d'aiguillage (Q'1a, Q'1b, Q'2a, Q'2b) adapté pour permettre soit une liaison directe soit une liaison croisée entre les branches différentielles et les charges résistives, et
des moyens (SWC) adaptés pour:
fournir des signaux (RSH, RSHb) au premier étage d'aiguillage pour commander l'autorisation et la dérivation des courants,
fournir des signaux (Rf, RFb) au deuxième étage d'aiguillage pour relier les branches différentielles aux charges résistives directement pendant une première moitié de la durée d'autorisation et de manière croisée pendant la deuxième moitié de la durée d'autorisation, de manière à inverser le signe du signal électrique de sortie entre les deux moitiés de cette durée.

2. Convertisseur selon la revendication 1, **caractérisé en ce que** le rapport cyclique est réglable.

3. Convertisseur selon l'une des revendications 1 et 2, **caractérisé en ce que** le calage temporel entre les fronts de transition des signaux qui commandent l'autorisation et la dérivation et le signal d'horloge est réglable, .

4. Convertisseur selon l'une des revendications 1 à 3, **caractérisé en ce que** l'ensemble de sources de courant comprend des sources de courant ayant des valeurs pondérées selon une pondération binaire.

5. Convertisseur selon l'une des revendications 1 à 4, **caractérisé en ce que** le circuit d'aiguillage comporte des paires de transistors associées à chaque branche différentielle pour effectuer un aiguillage symétrique pour les courants des deux branches différentielles, et des sources de courant auxiliaires identiques sont reliées aux deux branches différentielles entre le circuit d'aiguillage et une borne d'alimentation pour faire passer un courant non nul dans les paires de transistors associées aux deux branches.

## Patentansprüche

1. Digital-Analog-Umsetzer, der mindestens eine Gruppe von Stromquellen, ein jeweiliges Paar Differentialverzweigungen zu zwei Transistoren (T1, T2), das mit jeder Stromquelle verbunden ist, ein Register (REG), das mit einer Taktfrequenz F betätigt wird und eine umzusetzende digitale Angabe empfängt, wobei das Register die Transistoren der Verzweigungspaare steuert, um die Ströme der Stromquellen in der einen oder der anderen der Differentialverzweigungen jedes Paars in Abhängigkeit vom Wert der umzusetzenden digitalen Angabe zu verzweigen, und zwei ohmsche Belastungen (R1, R2), die die Ströme der Differentialverzweigungen empfangen, um ein elektrisches Differential-Ausgangssignal zu produzieren, dessen analoger Wert die umzusetzende digitale Angabe darstellt, aufweist, wobei der Umsetzer auch einen Verzweigungskreis zwischen den Differentialverzweigungen und den ohmschen Belastungen aufweist, wobei der Verzweigungskreis eine erste Verzweigungsstufe (Q1a, Q1b, Q2a, Q2b) umfasst, die ausgebildet ist, um entweder die Weiterleitung der Ströme der Differentialverzweigungen zu den ohmschen Belastungen zu genehmigen oder um diese Ströme um die ohmschen Belastungen umzuleiten,
**dadurch gekennzeichnet, dass**:
- die erste Verzweigungsstufe ausgebildet ist, um periodisch in der Taktfrequenz eine Umleitung, gefolgt von einer Genehmigung, aufzubauen, wobei das zyklische Verhältnis zwischen der Genehmigungsdauer und der Taktperiode zwischen 0,7 und 0,95 ist,
- der Verzweigungskreis ferner umfasst:
eine zweite Verzweigungsstufe (Q'1a, Q'1b, Q'2a, Q'2b), die ausgebildet ist, um entweder eine direkte Verbindung oder eine Kreuzverbindung zwischen den Differentialverzweigungen und den ohmschen Belastungen zu genehmigen, und
Mittel (SWC), die ausgebildet sind, um:
der ersten Verzweigungsstufe Signale (RSH, RSHb) bereitzustellen, um die Genehmigung und die Umleitung der Ströme zu steuern,
der zweiten Verzweigungsstufe Signale (Rf, RFb) bereitzustellen, um die Differentialverzweigungen mit den ohmschen Belastungen direkt während einer ersten Hälfte der Genehmigungsdauer und überkreuz während der zweiten Hälfte der Genehmigungsdauer zu verbinden, um zwischen den zwei Hälften dieser Dauer das Zeichen des elektrischen Ausgangssignals umzukehren.

2. Umsetzer nach Anspruch 1, **dadurch gekennzeichnet, dass** das zyklische Verhältnis einstellbar ist.

3. Umsetzer nach einem der Ansprüche 1 und 2, **dadurch gekennzeichnet, dass** zeitliche Justierung zwischen den Transitionsfronten der Signale, die die Genehmigung und die Umleitung und das Taktsignal steuern, einstellbar ist.

4. Umsetzer nach einem der Ansprüche 1 bis 3, **dadurch gekennzeichnet, dass** die Stromquellengruppe Stromquellen umfasst, die gemäß einer binären Wichtung gewichtete Werte haben.

5. Umsetzer nach einem der Ansprüche 1 bis 4, **dadurch gekennzeichnet, dass** der Verzweigungskreis jeder Differentialverzweigung zugeordnete Transistorpaare aufweist, um eine symmetrische Verzweigung für die Ströme der zwei Differentialverzweigungen durchzuführen, und identische Hilfsstromquellen mit den zwei Differentialverzweigungen zwischen dem Verzweigungskreis und einer Versorgungsklemme verbunden sind, um einen Strom ungleich Null in die den zwei Verzweigungen zugeordnete Transistorpaare zu leiten.

## Claims

1. A digital-to-analog converter having at least a set of current sources, a respective pair of differential branches with two transistors (T1, T2) connected to each current source, a register (REG) activated at a clock frequency F and receiving a digital data element to be converted, the register controlling the transistors of the pairs of branches to switch the currents from the current sources individually into one or other of the differential branches of each pair as a function of the value of the digital data element to be converted, and two resistive loads (R1, R2) receiving the currents of the differential branches to produce a differential output electrical signal whose analog value represents the digital data element to be converted, the converter also having a switching circuit interposed between the differential branches and the resistive loads, the switching circuit comprising a first switching circuit (Q1a, Q1b, Q2a, Q2b) suitable either for enabling transmission toward the resistive loads of the currents of the differential branches or for diverting said currents away from the resistive loads, **characterized in that**:
- the first switching circuit is configured to establish diverting periodically at the clock frequency, followed by an enabling operation, the duty cycle between the enabling time and the clock period being in the range from 0.7 to 0.95,
- the switching circuit further comprises a second switching stage (Q'1a, Q'1b, Q'2a, Q'2b) suitable for allowing either a direct link or a cross link between the differential branches and the resistive loads, and means (SWC) suitable for:
providing signals (RSH, RSHb) to the first switching stage to control the enabling and diverting of the currents,
providing signals (Rf, RFb)) to the second switching stage to connect the differential branches to the resistive loads directly during a first half of the enabling time and in a crossed manner during the second half of the enabling time, so as to reverse the sign of the electrical output signal between the two halves of this time.

2. The converter as claimed in claim 1, **characterized in that** the duty cycle is adjustable.

3. The converter as claimed in either of claims 1 and 2, **characterized in that** time alignment between the transition edges of the signals controlling enabling and diverting and the clock signal is adjustable.

4. The converter as claimed in any of claims 1 to 3, **characterized in that** the set of current sources comprises current sources having values weighted according to a binary weighting.

5. The converter as claimed in any of claims 1 to 4, **characterized in that** the switching circuit has pairs of transistors associated with each differential branch to provide symmetrical switching for the currents of the two differential branches, and identical auxiliary current sources are connected to the two differential branches between the switching circuit and a power supply terminal to cause a non-zero current to flow in the pairs of transistors associated with the two branches.
